# EUROPEAN PATENT APPLICATION

(11) **EP 3 010 139 A1**
(43) Date of publication of application: **20.04.2016**
(21) Application number: 14810858.2
(22) Date of filing: 11.06.2014
(51) Int. Cl.: H02N 11/00, H01L 35/30

(54) **THERMOELECTRIC GENERATION DEVICE**

(30) Priority: 11.06.2013 JP 2013122525
(71) Applicant: Hokkaido Tokushushiryou Kabushikikaisha, Hokkaido 060-0013 (JP)
(72) Inventor: ONOSE, Kazuhiro, Kamikawa-gun Hokkaido 089-0101 (JP)
(74) Representative: Gosdin, Michael
(86) International application number: PCT/JP2014/065414
(87) International publication number: WO 2014/200004

(57) **Abstract**

A thermoelectric generator is provided that can perform thermoelectric generation efficiently. This generator (1) includes: a first heat medium chamber (10) into which a first heat medium (M1) flows and out of which the first heat medium (M1) flows; a first chamber wall (11) which defines the first heat medium chamber (10); a second heat medium chamber (20) into which a second heat medium (M2) flows and out of which the second heat medium (M2) flows; a second chamber wall (21) which defines the second heat medium chamber (20); and thermoelectric generation layers (45-1, 45-2). The two second heat medium chambers (20) are within the first heat medium chamber (10). Both the second heat medium chambers (20) are separated from each other and are arranged parallel to each other. The first chamber wall (11) and the second chamber wall (21) are not in contact with each other, and the temperature of the first heat medium (M1) and the temperature of the second heat medium (M2) are different from each other. The thermoelectric generation layers (45-1, 45-2) are provided on the outer surface of the first chamber wall (11) and the outer surface of the second chamber wall (21).

## Description

### Technical Field

The present invention relates to a technology in which a thermoelectric element is used to covert thermal energy into electric energy.

### Background Art

A technology is known in which heat discharged from a thermal engine is utilized to perform power generation.

As an example thereof, there is a thermoelectric generation module in which a generation layer formed with a thermoelectric conversion element is provided between an inner tube and an outer tube, in which a high-temperature heat medium (hot water, vapor, discharge gas or the like) is introduced into the inner tube from a boiler or an internal combustion engine and in which power generation is performed by a temperature difference between the inner tube and the outer tube (Patent Literature 1).

In the technology disclosed in Patent Literature 1, since the temperature of the inner tube through which the high-temperature heat medium is passed is lower than the temperature of the outer tube in contact with outside air, a temperature difference between them is utilized, and thus it is possible to perform power generation by thermoelectric conversion.

### Citation List - Patent Literature

Patent Literature 1: Japanese Unexamined Patent Application Publication No. 9-36439 (Japanese Patent No. 2275410)

### Summary of Invention

### Technical Problem

However, in the technology disclosed in Patent Literature 1, since thermoelectric conversion is performed only by the generation layer arranged in the space of a singular layer between the inner tube and the outer tube, it is impossible to perform thermoelectric generation by efficiently utilizing a temperature difference produced by a heat energy source. Moreover, in the technology disclosed in Patent Literature 1, since thermoelectric conversion is performed by a relatively low temperature difference between the high-temperature heat medium and the outside air, there is a fundamental problem in which the efficiency of the power generation is not satisfactory.

In order to solve this problem, an object of the present invention is to provide a thermoelectric generator that can perform thermoelectric generation more efficiently than a conventional thermoelectric generator.

### Solution to Problem

A thermoelectric generator (aspect 1) includes: a first heat medium chamber into which a first heat medium flows and out of which the first heat medium flows; a first chamber wall which defines the first heat medium chamber; a second heat medium chamber into which a second heat medium flows and out of which the second heat medium flows; a second chamber wall which defines the second heat medium chamber; a first thermoelectric generation layer which performs power generation by a temperature difference; and a second thermoelectric generation layer which performs power generation by a temperature difference, where the second heat medium chamber is within the first heat medium chamber, the first chamber wall and the second chamber wall are not in contact with each other, a temperature of the first heat medium and a temperature of the second heat medium are different from each other, the first thermoelectric generation layer is provided on an outer surface or an inner surface of the first chamber wall and the second thermoelectric generation layer is provided on an outer surface or an inner surface of the second chamber wall.

In this generator, the first heat medium is made to flow into the first heat medium chamber, and the second heat medium is made to flow into the second heat medium chamber, and thus a temperature difference is produced between the first heat medium chamber and the second heat medium chamber and a temperature difference is produced between the first heat medium chamber and the heat medium outside it. The second thermoelectric generation layer performs power generation by utilizing the temperature difference between the first heat medium chamber and the second heat medium chamber. The first thermoelectric generation layer performs power generation by utilizing the temperature difference between the first heat medium chamber and the heat medium outside it.

In this generator, since a plurality of thermoelectric generation layers arranged between the heat media whose temperatures are different from each other and which are placed inside and outside are used to perform power generation by thermoelectric conversion, it is possible to perform thermoelectric generation more efficiently than conventional thermoelectric generation.

A thermoelectric generator (aspect 2) includes: a first heat medium chamber into which a first heat medium flows and out of which the first heat medium flows; a first chamber wall which defines the first heat medium chamber; a second heat medium chamber into which a second heat medium flows and out of which the second heat medium flows; a second chamber wall which defines the second heat medium chamber; a first thermoelectric generation layer which performs power generation by a temperature difference; and a second thermoelectric generation layer which performs power generation by a temperature difference, where the second heat medium chamber is within the first heat medium chamber, the first chamber wall and the second chamber wall are not in contact with each other, a temperature of the first heat medium and a temperature of the second heat medium are different from each other, the first thermoelectric generation layer is provided on an outer surface or an inner surface of the first chamber wall, the second thermoelectric generation layer is provided on an outer surface or an inner surface of the second chamber wall, the first heat medium chamber is a combustion chamber and a temperature of the second heat medium flowing into the second heat medium chamber is lower than a temperature of the first heat medium chamber.

In this generator, the first heat medium is made to flow into the first heat medium chamber, and the second heat medium is made to flow into the second heat medium chamber, and thus a temperature difference is produced between the first heat medium chamber and the second heat medium chamber and a temperature difference is produced between the first heat medium chamber and the heat medium outside it. The second thermoelectric generation layer performs power generation by utilizing the temperature difference between the first heat medium chamber and the second heat medium chamber. The first thermoelectric generation layer performs power generation by utilizing the temperature difference between the first heat medium chamber and the space outside it. Since the first heat medium chamber is a combustion chamber, and the combustion chamber has an extremely high temperature, a significant temperature difference is produced between the first heat medium chamber and the second heat medium chamber and between the first heat medium chamber and the space outside it.

Hence, in this generator, a plurality of power generation layers, that is, the first and second thermoelectric generation layers are used, a significant temperature difference is produced between regions sandwiching the power generation layers and thus it is possible to perform power generation by thermoelectric conversion, with the result that it is possible to perform thermoelectric generation more efficiently than conventional thermoelectric generation.

A thermoelectric generator (aspect 3) includes: a first heat medium chamber into which a first heat medium flows and out of which the first heat medium flows; a first chamber wall which defines the first heat medium chamber; a second heat medium chamber into which a second heat medium flows and out of which the second heat medium flows; a second chamber wall which defines the second heat medium chamber; a first thermoelectric generation layer which performs power generation by a temperature difference; and a second thermoelectric generation layer which performs power generation by a temperature difference, where the second heat medium chamber is within the first heat medium chamber, the first chamber wall and the second chamber wall are not in contact with each other, a temperature of the first heat medium and a temperature of the second heat medium are different from each other, the first thermoelectric generation layer is provided on an outer surface or an inner surface of the first chamber wall, the second thermoelectric generation layer is provided on an outer surface or an inner surface of the second chamber wall, the first chamber wall is a chamber wall that separates an outdoor area and an indoor area, the second heat medium chamber is within the indoor area, a temperature of the second heat medium flowing into the second heat medium chamber is lower than a temperature of the indoor area, in the indoor area, an electronic device serving as a heat source is stored and the second heat medium is a heat medium for cooling air in the indoor area.

In this generator, the first heat medium is made to flow into the first heat medium chamber, and the second heat medium is made to flow into the second heat medium chamber, and thus a temperature difference is produced between the first heat medium chamber and the second heat medium chamber and a temperature difference is produced between the first heat medium chamber and the space outside it. The second thermoelectric generation layer performs power generation by utilizing the temperature difference between the first heat medium chamber and the second heat medium chamber. The first thermoelectric generation layer performs power generation by utilizing the temperature difference between the first heat medium chamber and the space outside it. Since the first heat medium chamber is a chamber wall that separates the outdoor area and the indoor area, and in the indoor area, the electronic device serving as the heat source is stored, a significant temperature difference is produced between the first heat medium chamber and the space outside it. Since the second heat medium is a heat medium for cooling the air in the indoor area, a significant temperature difference is produced between the first heat medium chamber and the second heat medium chamber.

Hence, in this generator, a plurality of power generation layers, that is, the first and second thermoelectric generation layers are used, a significant temperature difference is produced between regions sandwiching the power generation layers and thus it is possible to perform power generation by thermoelectric conversion, with the result that it is possible to perform thermoelectric generation more efficiently than conventional thermoelectric generation. Since in particular, in a cold region, a significant temperature difference is produced between an outdoor area and an indoor area, it is possible to perform thermoelectric generation extremely efficiently.

### Advantageous Effects of Invention

In the present invention, since a plurality of thermoelectric generation layers arranged between the heat mediums whose temperatures are different from each other and which are placed inside and outside are used to perform power generation by thermoelectric conversion, it is possible to perform thermoelectric generation more efficiently than conventional thermoelectric generation.

In the present invention, since a plurality of thermoelectric generation layers arranged between the heat mediums whose temperatures are different from each other and which are placed inside and outside are used, a significant temperature difference is produced between the heat mediums inside and outside the thermoelectric generation layers and thus it is possible to perform power generation by thermoelectric conversion, with the result that it is possible to perform thermoelectric generation more efficiently than conventional thermoelectric generation.

### Brief Description of Drawings

- Fig. 1(A):: A perspective view showing an embodiment of the present invention; and
- Fig. 1(B):: A cross-sectional view taken along line A-A of Fig. 1(A);
- Fig. 2:: A cross-sectional view showing another embodiment of the present invention; and
- Fig. 3:: A perspective view showing yet another embodiment of the present invention.

### Description of Embodiments

Embodiments of the present invention will be described below with reference to drawings.

### First embodiment

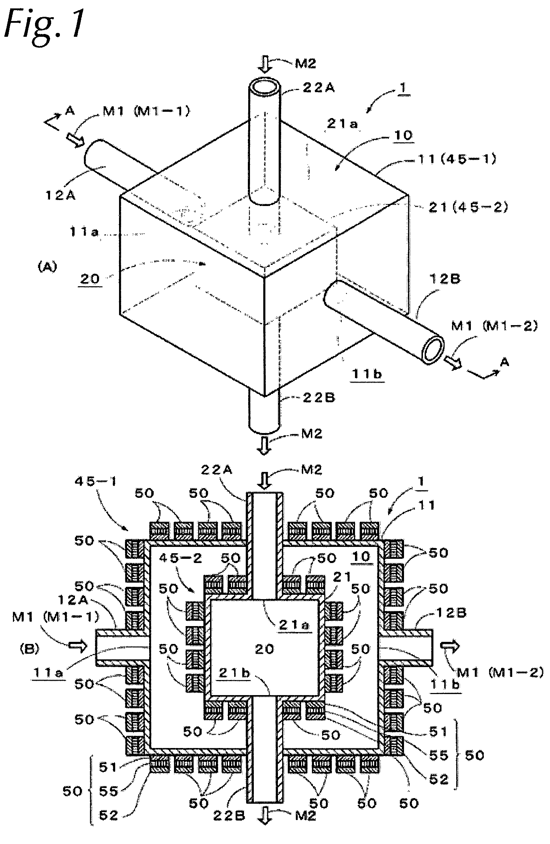

A thermoelectric generator 1 shown in Fig. 1 includes a first heat medium chamber 10, a first chamber wall 11, a second heat medium chamber 20, a second chamber wall 21, a first thermoelectric generation layer 45-1 and a second thermoelectric generation layer 45-2.

The first heat medium chamber 10 is a heat medium chamber into which a first heat medium M1 flows and out of which the first heat medium M1 flows.

The first heat medium chamber 10 is a combustion chamber.

The second heat medium chamber 20 is a heat medium chamber into which a second heat medium M2 flows and out of which the second heat medium M2 flows.

The second heat medium chamber 20 is within the first heat medium chamber 10.

The first chamber wall 11 and the second chamber wall 21 are not in contact with each other.

The first chamber wall 11 is a wall that defines the first heat medium chamber 10.

The first chamber wall 11 is formed of a metal that has both heat transfer and heat resistant properties. Examples of this type of metal can include stainless steel.

The first chamber wall 11 is formed in the shape of a rectangular parallelepiped.

In the first chamber wall 11, an entrance 11a from which the first heat medium M1 (M1-1) flows in and an exit 11b from which the first heat medium M1 (M1-2) flows out are provided.

The first heat medium M1 (M1-1) flowing into the space surrounded by the first chamber wall 11, that is, the first heat medium chamber 10, is a mixture fluid containing a fuel and air.

The first heat medium M1 (M1-2) flowing out of the first heat medium chamber 10 is the fluid after combustion.

A medium supply tube 12A is connected to the entrance 11 a. A medium discharge tube 12B is connected to the exit 11b.

The second chamber wall 21 is a wall that defines the second heat medium chamber 20.

As with the first chamber wall 11, the second chamber wall 21 is formed of a metal that has both heat transfer and heat resistant properties.

The second chamber wall 21 is formed in the shape of a rectangular parallelepiped.

In the second chamber wall 21, an entrance 21 a from which the second heat medium M2 flows in and an exit 21b from which the second heat medium M2 flows out are provided.

The second heat medium M2 is a fluid whose temperature is lower than the temperature of the first heat medium chamber 10. Specific examples of this fluid can include groundwater, seawater, river water and tap water.

A medium supply tube 22A is connected to the entrance 21a. A medium discharge tube 22B is connected to the exit 21b. Both the medium supply tubes 22A and 22B penetrate the first chamber wall 11.

The area between the part of the first chamber wall 11 that is penetrated by both the medium supply tubes 22A and 22B and both the medium supply tubes 22A and 22B are hermetically sealed.

The first thermoelectric generation layer 45-1 is provided on the outer surface of the first chamber wall 11. The first thermoelectric generation layer 45-1 is in contact with outside air (the atmosphere).

The second thermoelectric generation layer 45-2 is provided on the outer surface of the second chamber wall 21. The second thermoelectric generation layer 45-2 is in contact with a high-temperature atmosphere of the first heat medium chamber 10.

The first thermoelectric generation layer 45-1 covers substantially the entire outer surface of the first chamber wall 11. The first thermoelectric generation layer 45-1 includes a large number of power generation elements 50 that are arranged orderly on the outer surface of the first chamber wall 11.

The second thermoelectric generation layer 45-2 covers substantially the entire outer surface of the second chamber wall 21. The second thermoelectric generation layer 45-2 includes a large number of power generation elements 50 that are arranged orderly on the outer surface of the second chamber wall 21.

The power generation element 50 includes an inner electrode 51, an outer electrode 52 and a thermoelectric conversion element 55 that is electrically connected between the outer electrode 52 and the inner electrode 51 and that performs power generation by a temperature difference produced between both ends.

A method of electrically connecting the power generation elements 50 in the first and second thermoelectric generation layers 45-1 and 45-2 is arbitrary. Any form can be adopted such as a form in which all the power generation elements 50 are electrically connected in parallel to each other, a form in which all the power generation elements 50 are electrically connected in series or a form of a series-parallel connection in which a series connection and a parallel connection are combined. Power generated by the first and second thermoelectric generation layers 45-1 and 45-2 is taken out from a pair of output terminals which are not shown.

The thermoelectric generator 1 configured as described above makes the first heat medium M1 flow into the first heat medium chamber 10, makes the second heat medium M2 flow into the second heat medium chamber 20 and thereby produces a temperature difference between the first heat medium chamber 10 and the second heat medium chamber 20 and produces a temperature difference between the first heat medium chamber 10 and the outside air. The second thermoelectric generation layer 45-2 utilizes temperature difference between the first heat medium chamber 10 and the second heat medium chamber 20 to perform power generation. The first thermoelectric generation layer 45-1 utilizes a temperature difference between the first heat medium chamber 10 and the outside air to perform power generation. The first heat medium chamber 10 is a combustion chamber, and since the combustion chamber has an extremely high temperature, a significant temperature difference is produced between the first heat medium chamber 10 and the second heat medium chamber 20 and between the first heat medium chamber 10 and the outside air.

Hence, in the thermoelectric generator 1, the first and second thermoelectric generation layers 45-1 and 45-2 are used to produce a significant temperature difference between regions sandwiching the generation layers 45-1 and 45-2, and thus it is possible to perform power generation by thermoelectric conversion, with the result that it is possible to perform thermoelectric generation more efficiently than conventional thermoelectric generation.

Although the thermoelectric generator 1 can also be used in a temperate region, it is installed outdoors in a cold region to produce a significant temperature difference between regions sandwiching the first thermoelectric generation layer 45-1, and thus it is possible to perform power generation more efficiently.

### Second embodiment

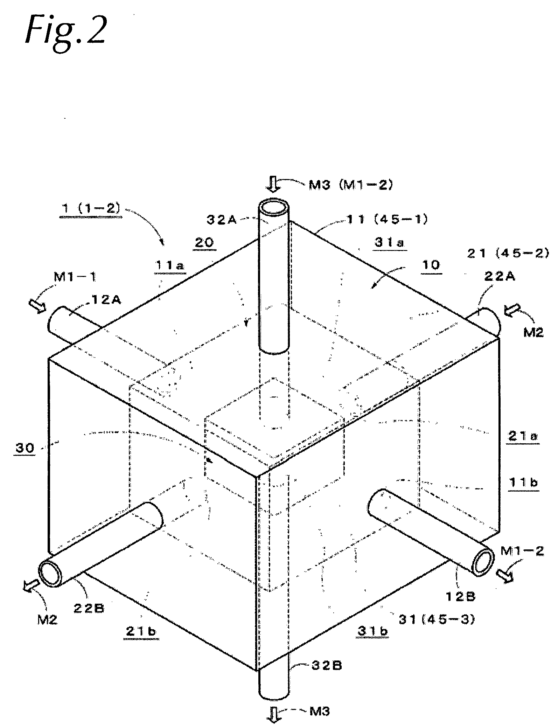

Although in the example described above, the generator of a two-chamber structure in which the second heat medium chamber 20 is provided within the first heat medium chamber 10 is described, the number of heat medium chambers is arbitrary. As shown in Fig. 2, a generator in which a third heat medium chamber 30 is further provided within the second heat medium chamber 20 is also included in the technical scope of the present invention.

The thermoelectric generator 1 (1-2) of Fig. 2 includes, in addition to the configuration of the generator of Fig. 1, the third heat medium chamber 30, a third chamber wall 31 and a third thermoelectric generation layer 45-3.

The third heat medium chamber 30 is a heat medium chamber into which a third heat medium M3 flows and out of which the third heat medium M3 flows.

The third chamber wall 31 is a wall that defines the third heat medium chamber 30.

As with the first and second chamber walls 11 and 12, the third chamber wall 31 is formed of a metal that has both heat transfer and heat resistant properties. The third chamber wall 31 is formed in the shape of a rectangular parallelepiped. In the third chamber wall 31, an entrance 31a from which the third heat medium M3 flows in and an exit 31b from which the third heat medium M3 flows out are provided.

The third heat medium M3 is a heat medium whose temperature is higher than the temperature of the third heat medium chamber 30. Specific examples of this heat medium can include the first heat medium M1 (M1-2) that flows out of the first heat medium chamber 10.

A medium supply tube 32A is connected to the entrance 31a. A medium discharge tube 32B is connected to the exit 31 b. Both the medium supply tubes 32A and 32B penetrate the first chamber wall 11 and the second chamber wall 21. The area between the part of the first chamber wall 11 that is penetrated by both the medium supply tubes 32A and 32B and both the medium supply tubes 32A and 32B are hermetically sealed. The area between the part of the second chamber wall 21 that is penetrated by both the medium supply tubes 32A and 32B and both the medium supply tubes 32A and 32B are hermetically sealed.

The third thermoelectric generation layer 45-3 is provided on the outer surface of the third chamber wall 31. The third thermoelectric generation layer 45-3 is in contact with the second heat medium M2. The third thermoelectric generation layer 45-3 covers substantially the entire outer surface of the third chamber wall 31. The third thermoelectric generation layer 45-3 includes, as with the first and second thermoelectric generation layers 45-1 and 45-2, a large number of power generation elements 50 that are arranged orderly on the outer surface of the third chamber wall 31. The third thermoelectric generation layer 45-3 performs power generation by a temperature difference between the second heat medium chamber 20 and the third heat medium chamber 30. Power generated by the third thermoelectric generation layer is taken out together with the power generated by the first and second thermoelectric generation layers 45-1 and 45-2.

### Third embodiment

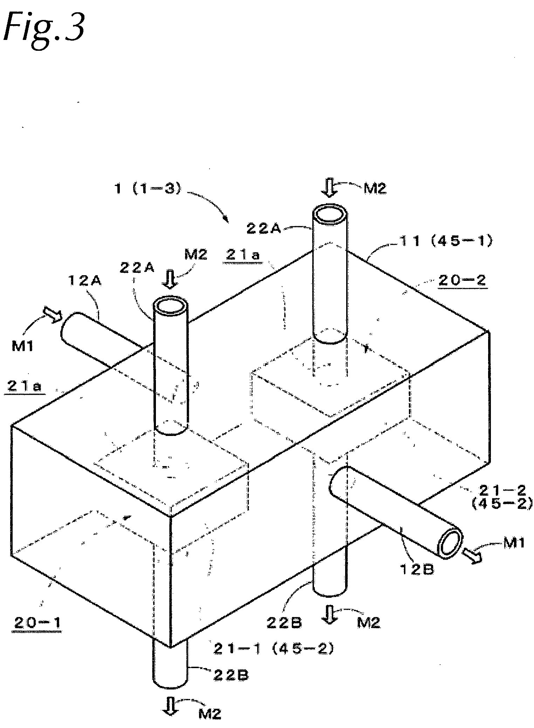

As shown in Fig. 3, a generator in which a plurality of second heat medium chambers 20 are provided within the first heat medium chamber 10 is also included in the technical scope of the present invention.

The thermoelectric generator 1 (1-3) of Fig. 3 includes two second heat medium chambers 20-1 and 20-2 and two second chamber walls 21-1 and 21-2 that define both the second heat medium chambers 20-1 and 20-2. Both the second chamber walls 21-1 and 21-2 are arranged parallel to each other.

### Other embodiments

Although in the example described above, on the outer surface of the chamber wall defining the heat medium chamber, the thermoelectric generation layer is provided, on the outer surface of the present chamber wall, the thermoelectric generation layer may be provided.

The shape of the heat medium chamber is not limited to the shape of a rectangular parallelepiped, and may be a spherical shape, a cylindrical shape, a tubular shape or another shape.

Although in the example described above, in the chamber walls 11, 21 and 31, the entrances 11a, 21a and 31a and the exits 11b, 21b and 31b are arranged in a coaxial manner, they may be arranged in a non-coaxial manner.

Although in the example discussed above, the case where the first heat medium chamber 10 is a combustion chamber is described, the second heat medium chamber 20 may be a combustion chamber, and a low-temperature heat medium such as water may be supplied to the first heat medium chamber 10.

Although in the example described above, only on the chamber walls 11, 21 and 31 defining the heat medium chamber, the thermoelectric generation layers 45-1, 45-2 and 45-3 are provided, the thermoelectric generation layers 45-1, 45-2 and 45-3 can be provided not only on the chamber walls 11, 21 and 31 but also on the outer surface or the inner surface of the medium supply tubes 12A, 12B, 22A, 22B, 32A and 32B.,

The shape of the medium supply tubes 12A, 22A and 32A and the medium discharge tubes 12B, 22B and 32B do not need to be a cylindrical shape. The medium supply tubes 12A, 22A and 32A and the medium discharge tubes 12B, 22B and 32B may be tubular members whose cross sections are rectangular. The medium supply tubes 12A, 12B, 22A, 22B, 32A and 32B may be part of the chamber wall defining the heat medium chambers 10, 20 and 30.

The configuration including the combustion chamber is simply an example of the thermoelectric generator of this invention.

The thermoelectric generator of this invention can also be applied to buildings.

Specifically, in the example of the configuration of Fig. 1, the first chamber wall 11 can be used as part of the outer wall of a building which separates the outdoor area and the indoor area, and the second heat medium chamber 20 defined by the second chamber wall 21 can be provided in the first heat medium chamber 10 defined by the first chamber wall 11, that is, in the outdoor area.

When an electronic device that generates a large amount of heat is stored indoors, it is possible to perform power generation with the first thermoelectric generation layer 45-1 by utilizing a difference between an indoor temperature and an outdoor temperature. When a heat medium (such as water or outside air) for cooling indoor air is supplied to the second heat medium chamber 20, it is possible to perform power generation with the second thermoelectric generation layer 45-2 by utilizing a temperature difference between the second heat medium chamber 20 and the indoor area (the first heat medium chamber 10). In a cold region, since a large temperature difference is produced between an outdoor area and an indoor area, it is possible to perform thermoelectric generation extremely efficiently.

### Industrial Applicability

In the thermoelectric generator of the present invention, a system that uses a high-temperature vapor for power generation, such as a nuclear power plant, a thermal power plant or a geothermal power plant is used as a heat energy source, and thus it is possible to perform power generation. For example, when a nuclear power plant is used as a heat energy source, a high-temperature vapor passing through a turbine is passed through a high-temperature flow path as a high-temperature heat medium, and seawater is passed through a low-temperature flow pass as a low-temperature heat medium, with the result that it is possible to perform thermoelectric generation by utilizing a significant temperature difference therebetween. It is also possible to use, as a high-temperature heat medium, a high-temperature vapor heated by the decay heat of a fuel or the like. Hence, it is possible to perform thermoelectric generation even when a nuclear reactor is stopped.

In the thermoelectric generator of the present invention, a data center is used as a heat energy source, and thus it is possible to perform power generation. Specifically, air that is heated by heat produced in electronic devices (such as a server and a storage) within the data center is passed through a high-temperature flow pass as a high-temperature heat medium, and water (such as seawater, groundwater or river water) or outside air is passed through a low-temperature flow pass as a low-temperature heat medium, with the result that it is possible to perform thermoelectric generation by utilizing a temperature difference therebetween. Power obtained by the thermoelectric generation described above is consumed in the data center, and thus it is possible to facilitate energy saving in the data center.

### List of Reference Signs:

- 1: thermoelectric generator
- 10: first heat medium chamber
- 11: first chamber wall
- 11a: entrance
- 11b: exit
- 12A: medium supply tube
- 12B: medium discharge tube
- 20: second heat medium chamber
- 21: second chamber wall
- 21a: entrance
- 21b: exit
- 22A: medium supply tube
- 22B: medium discharge tube
- 30: third heat medium chamber
- 31: third chamber wall
- 31a: entrance
- 31b: exit
- 32A: medium supply tube
- 32B: medium discharge tube
- 45-1: first thermoelectric generation layer
- 45-2: second thermoelectric generation layer
- 45-3: third thermoelectric generation layer
- 50: power generation element
- M1: first heat medium
- M2: second heat medium
- M3: third heat medium

## Claims

1. Thermoelectric generator (1) comprising:
a first heat medium chamber (10) into which a first heat medium (M1) flows and out of which the first heat medium (M1) flows;
a first chamber wall (11) which defines the first heat medium chamber (10);
a second heat medium chamber (20) into which a second heat medium (M2) flows and out of which the second heat medium (M2) flows;
a second chamber wall (21) which defines the second heat medium chamber (20);
a first thermoelectric generation layer (45-1) which performs power generation by a temperature difference; and
a second thermoelectric generation layer (45-2) which performs power generation by a temperature difference,
wherein the second heat medium chamber (20) is within the first heat medium chamber (10),
the first chamber wall (11) and the second chamber wall (21) are not in contact with each other,
a temperature of the first heat medium (M1) and a temperature of the second heat medium (M2) are different from each other,
the first thermoelectric generation layer (45-1) is provided on an outer surface or an inner surface of the first chamber wall (11) and
the second thermoelectric generation layer (45-2) is provided on an outer surface or an inner surface of the second chamber wall (21).

2. Thermoelectric generator according to claim 1, **characterized in that** a plurality of the second heat medium chambers (20) are within the first heat medium chamber (10).

3. Thermoelectric generator according to claim 1, **characterized in that** the first heat medium chamber (10) is a combustion chamber, and a temperature of the second heat medium (M2) flowing into the second heat medium chamber (20) is lower than a temperature of the first heat medium chamber (10).

4. Thermoelectric generator according to claim 1, **characterized in that** the first chamber wall (11) is a part of a wall that separates an outdoor area and an indoor area, the second heat medium chamber (20) is within the indoor area and a temperature of the second heat medium (M2) flowing into the second heat medium chamber is lower than a temperature of the indoor area.

5. Thermoelectric generator according to claim 4, **characterized in that** in the indoor area, an electronic device serving as a heat source is stored, and the second heat medium (M2) is a heat medium for cooling air in the indoor area.
